# EUROPÄISCHE PATENTANMELDUNG

(11) **EP 0 789 065 A2**
(43) Veröffentlichungstag der Anmeldung: **13.08.1997**
(21) Anmeldenummer: 97101086.3
(22) Anmeldetag: 24.01.1997
(51) Int. Cl.: C09D 167/08, C09D 167/06

(54) **Strahlenhärtbare Mischung und ihre Verwendung**

(30) Priorität: 06.02.1996 DE 19604185
(71) Anmelder: BAYER AG, 51368 Leverkusen (DE)
(72) Erfinder: Meixner, Jürgen, Dr., 47803 Krefeld (DE); Fischer, Wolfgang, Dr., 40668 Meerbusch (DE); Müller, Manfred, 41006 Mönchengladbach (DE); Ruf, Günter, Dr., 47809 Krefeld (DE)

(57) **Zusammenfassung**

Die Erfindung betrifft eine neue strahlenhärtbare Lackkomposition und ihre Verwendung zur Beschichtung von unterschiedlichen Substraten mit ausgezeichneter Haftung und damit hergestellte Lacke.

## Beschreibung

Die Erfindung betrifft eine neue strahlenhärtbare Lackkomposition und ihre Verwendung zur Beschichtung von unterschiedlichen Substraten mit ausgezeichneter Haftung und damit hergestellte Lacke.

Normalerweise bestehen Bindemittel, die für strahlenhärtbare Beschichtungen eingesetzt werden, im wesentlichen aus ungesättigten Polyesterharzen (mit Maleinat und/oder Fumaratgruppen) oder ungesättigten Acrylatharzen (mit Acryloylgruppen).

Fettsäure-modifizierte Polyesterharze (Alkydharze) werden entweder durch Autoxidation oder durch Reaktion mit Melaminharzen oder Polyisocyanaten vernetzt.

Die DE-A 38 03 141 beschreibt Lacke auf Basis von ethylenisch ungesättigten, polymeren Bindemitteln, wobei diese auch Alkydharze sein können, und niedermolekularen, ungesättigten Verbindungen. Diese werden ebenfalls durch autoxidative Trocknung unter Katalyse durch Metallsikkative vernetzt.

Die JP-A 62 129 364/85 schließlich beschreibt spezielle, gesättigte Polyester, die in (Meth)Acrylsäuremonomeren gelöst werden und strahlenvernetzbar sein sollen. Für eine Anwendung als z.B. Holzbeschichtung sind diese Bindemittel nicht geeignet, weil sie nur eine geringe Reaktivität aufweisen.

Ein Problem aller radikalisch aushärtbarer Beschichtungen ist die mangelhafte Haftung auf problematischen Untergründen wie Teakholz, Druckfarben, Melaminfolien und Metallen.

Es wurde nun gefunden, daß Mischungen aus u.a. Fettsäuren enthaltenden Polyesterharzen und (Meth)Acryloylgruppen enthaltenden, niederviskosen Verbindungen sehr gut unter Bestrahlung aushärtbar sind und dabei Beschichtungen ergeben, die eine ausgezeichnete Haftung auch auf den oben genannten problematischen Untergründen besitzen.

Diese Mischungen können auch den üblichen strahlenhärtbaren Materialien zugegeben werden und verbessern dabei die Haftungseigenschaften auch dieser Bindemittel.

Gegenstand der Erfindung ist eine durch Strahlen hartbare Lackkomposition aus
I) 0 bis 95 Gew.-Teilen mindestens eines strahlenhärtbaren Bindemittels mit Maleinat und/oder Fumarat und/oder Acryloylgruppen.
II) 5 bis 100 Gew.-Teilen eines Gemischs aus
   A) 20 bis 80 Gew.-Teilen mindestens eines Fettsäure-modifizierten Polyesterharzes
   B) 20 bis 80 Gew.-Teilen (Meth)Acryloylgruppen enthaltender Verbindungen einer Viskosität bei 23°C von 10 bis 1.000 mPa.s und des Molekulargewichtsbereichs Mₙ 170 bis 1.000,
   wobei die Summe der Gewichtsteile I) und II) sowie A) und B) jeweils 100 beträgt, sowie gegebenenfalls
III) aus der Technologie der Polyesterharze bekannten weiteren Hilfs- und Zusatzstoffen,
   dadurch gekennzeichnet, daß die Komponente A) mindestens 20 Gew.-% einer Fettsäure des Molekulargewichtsbereichs Mₙ 112 bis 400 enthält.

Als Komponente I) können Bindemittel mit Maleinat und/oder Fumaratgruppen (ungesättigte Polyesterharze) wie sie z.B. in der DE-A 16 94 149 beschrieben sind, und/oder mit Acryloylgruppen, wie sie z.B. in R. Holman, P. Oldring (Hrsg.) "UV + EB Curing Formulations for Printing Inks, Coatings and Paints", Sita Technologie, London 1988 beschrieben sind, verwendet werden.

Als Komponente A) kommen Fettsäure-enthaltende, gegebenenfalls urethanmodifizierte Polyesterharze (Alkydharze) zum Einsatz.

Unter Fettsäuren versteht man gesättigte oder ungesättigte, geradkettige oder verzweigte Monocarbonsäuren der aliphatischen Kohlenwasserstoffreihe.

Die Herstellung dieser Polyesterharze erfolgt z.B. durch eine an sich bekannte Umsetzung von Carbonsäuren a) und Alkoholen b), wobei diese Umsetzung gegebenenfalls unter Zuhilfenahme von üblichen Veresterungskatalysatoren vorzugsweise nach dem Prinzip einer Schmelz- oder Azeotropkondensation, gegebenenfalls auch unter Anlegen eines Vakuums, bei Temperaturen von 140 bis 270°C unter Wasserabspaltung erfolgt.

Für die Veresterungsreaktion geeignete Carbonsäuren a) sind beispielsweise gesättigte und/oder olefinisch ungesättigte, aliphatische Monocarbonsäuren mit 2 bis 22, vorzugsweise 6 bis 20 Kohlenstoffatomen, gesättigte und/oder olefinisch ungesättigte cycloaliphatische Monocarbonsäuren mit 6 bis 15, vorzugsweise 7 bis 10 Kohlenstoffatomen, aromatische Monocarbonsäuren mit 7 bis 15, vorzugsweise mit 7 bis 11 Kohlenstoffatomen, gesättigte und/oder olefinisch ungesättigte, aliphatische Polycarbonsäuren bis 4 bis 12, vorzugsweise 4 bis 8 Kohlenstoffatomen, gesättigte und/oder olefinisch ungesättigte, cycloaliphatische Polycarbonsäuren mit 6 bis 15, vorzugsweise 8 Kohlenstoffatomen, die diesen cycloaliphatischen Polycarbonsäuren entsprechenden aromatischen Polycarbonsäuren und/oder die Anhydride der zur intramolekularen Anhydridbildung befähigten Polycarbonsäuren.

Beispielhaft genannt seien Monocarbonsäuren wie Essigsäure, Propionsäure, Buttersäure, Valeriansäure, Capronsäure, Caprylsäure, Perlargonsäure, Caprinsäure, Laurinsäure, Myristinsäure, Palmitinsäure, Stearinsäure, Arachinsäure, Behensäure, Acrylsäure, Crotonsäure, Rizinolsäure, Benzoesäure, Hexahydrobenzoesäure, Tetrahydrobenzoesäure, Abietinsäure, Zimtsäure, 1-Naphthylsäure oder Polycarbonsäuren wie Maleinsäure, Maleinsäureanhydrid, Fumarsäure, Bernsteinsäure, Oxalsäure, Adipinsäure, Phthalsäure, Phthalsäureanhydrid, Isophthalsäure, Terephthalsäure, Tetrahydrophthalsäure, Tetrahydrophthalsäureanhydrid, Hexahydrophthalsäure, Hexahydrophthalsäureanhydrid, 1,4-Cyclohexandicarbonsäure, Glutarsäure, Pimelinsäure, Korksäure, Azelainsäure, Sebacinsäure, Sorbinsäure, Nonandicarbonsäure, Decandicarbonsäure, Undecandicarbonsäure, Norbornendicarbonsäure, Äpfelsäure, Weinsäure, Trimellithsäure, Trimellithsäureanhydrid, Pyromellithsäure, Pyromellithsäureanhydrid und/oder deren Gemische.

Besonders geeignet sind die aus natürlichen Quellen stammenden Fettsäuregemische, die auch in technisch aufbereiteter und modifizierter Form eingesetzt werden können. Hierzu zählen beispielhaft Rizinußölfettsäure, Kokosnußölfettsäure, Baumwollsaatölfettsäure, Rapsölfettsäure, Sojabohnenölfettsäure, Sonnenblumenölfettsäure, Erdnußölfettsäure, Tallölfettsäure, Talgfettsäure, Heringölfettsäure oder Walölfettsäure, die als natürliche und/oder synthetische Gemische bzw. als Umesterungsprodukte mit Polyolen einsetzbar sind.

Die Komponente A) enthält 20 bis 80 Gew.-%, vorzugsweise 25 bis 80 Gew.-%, einer Fettsäure des Molekulargewichtsbereichs Mₙ 112 bis 400, vorzugsweise 144 bis 340.

Für die Veresterungsreaktion geeignete Alkohole b) sind beispielsweise aliphatische bzw. cycloaliphatische Diole, wie z.B. Ethylenglykol, 1,3- und 1,2-Propylenglykol, 1,4-, 1,3- und 2,3-Butandiol, 1,6-Hexandiol, Diethylenglykol, Triethylenglykol, 1,8-Octandiol, hydrierte Bisphenole, 1,4-Cyclohexandiol, 1,4-Cyclohexandimethanol und Neopentylglykol.

Besonders gut geeignet sind höherfunktionelle Polyol-Komponenten, die zumindest aus einem drei- oder vierwertigen Alkohol des Molekulargewichtsbereichs 92-700 bestehen. Geeignete höherfunktionelle Alkohole sind beispielsweise Glycerin, Trimethylolpropan und Pentaerythrit oder deren alkoxylierte Derivate. Natürlich sind auch Gemische aus Diolen und Polyolen einsetzbar.

Im Falle einer azeotropen Veresterung der Komponenten wird das Schleppmittel, üblicherweise Isooctan, Xylol, Toluol oder Cyclohexan, nach beendeter Reaktion im Vakuum abdestilliert.

Gewünschtenfalls kann sich nach der Veresterungsreaktion auch eine Urethanisierungsreaktion anschließen. Hierzu setzt man den entstandenen Polyester, der dazu freie OH-Gruppen besitzen muß, in einer an sich bekannten Additionsreaktion mit Isocyanat um. Geeignete Isocyanate sind beispielsweise Toluylendiisocyanat, Hexamethylendiisocyanat und Isophorondiisocyanat.

(Meth)Acryloylgruppen enthaltende Verbindungen B) sind (Meth)Acrylatgruppen aufweisende Verbindungen des Molekulargewichtsbereichs Mₙ 170 bis 1.000 wie beispielsweise die (Meth)Acrylsäureester von Ethylenglykol, Propylenglykol, Dipropylenglykol, Butandiol, Hexandiol, Glycerin, Trimethylolpropan, Pentaerythrit, Sorbit oder die entsprechenden (Meth)Acrylsäureester der diesen Alkoholen entsprechenden Polyetheralkohole, wie sie in an sich bekannter Weise durch Alkoxylierung unter Verwendung von Propylenoxid und/oder Ethylenoxid der genannten Alkohole erhalten werden können.

Das Gewichtsverhältnis der Komponenten I) : II) beträgt 0: 100 bis 95: 5, vorzugsweise 0:100.

Das Gewichtsverhältnis der Komponenten A) : B) beträgt 20 : 80 bis 80 : 20, vorzugsweise 30 : 70 bis 70 : 30.

Die erfindungsgemäßen Lackkompositionen können mit Hilfs- und Zusatzmitteln III) der unterschiedlichsten Art abgemischt werden. Hierzu gehören Füllstoffe, Pigmente, Farbstoffe, Thixotropiermittel, Sikkative, Lösungsmittel, Glättmittel, Mattierungsmittel oder Verlaufsmittel, die in den üblichen Mengen eingesetzt werden können.

Gegenstand der Erfindung ist auch die Verwendung dieser Lackkomposition zur Beschichtung der unterschiedlichsten Substrate, wie z.B. Papier, Kartonage, Leder, Holz, Kunststoffe, Vlies, Textilien, keramische Materialien, fotografische Materialien, wie z.B. mit fotografischer Schicht versehenes Papier. Bevorzugte Substrate sind Holz, Druckfarben, Kunststoffolien und Metalle.

Bei der erfindungsgemäßen Verwendung erfolgt die Aushärtung, gegebenenfalls nach Verdunsten von flüchtigen Hilfsmitteln, wie inerte Lösungsmittel, mittels energiereicher Strahlung, wie Elektronen- oder Gammastrahlen oder vorzugsweise mittels UV- Licht (180 bis 300 nm).

Im Falle der Vernetzung mittels UV-Bestrahlung ist es notwendig, den Überzugsmassen Fotoinitiatoren hinzuzufügen.

Als Fotoinitiatoren sind die üblicherweise eingesetzten Verbindungen geeignet, wie sie z.B. in Houben-Weyl, Methoden der organischen Chemie, Band E 20, Seite 80 ff., Georg Thieme Verlag, Stuttgart 1987, beschrieben sind.

Gut geeignet sind z.B. Benzoinether wie Benzoinisopropylether, Benzilketale, wie z.B. Benzildimethylketal und Hydroxyalkylphenone, wie z.B. 1-Phenyl-2-hydroxy-2-methylpropan-1-on.

Die erwähnten Fotoinitiatoren, die je nach Verwendungszweck der erfindungsgemäßen Produkte in Mengen zwischen 0,5 bis 10 Gew.-%, vorzugsweise 1 bis 8 Gew.-%, bezogen auf das Gesamtgewicht der Komponenten I) + II) eingesetzt werden, können als einzelne Substanz oder, wegen häufiger vorteilhafter synergistischer Effekte, auch in Kombination miteinander verwendet werden.

### Beispiele

Alle Prozentangaben beziehen sich auf das Gewicht.

### I. Allgemeine Herstellvorschrift der Fettsäure-modifizierten Polyesterharze (Komponente A)

Die Rohstoffe der Tabelle 1 werden unter Durchleiten von Stickstoff auf 250°C aufgeheizt und bei dieser Temperatur gehalten, bis eine Viskosität (60 %ig in Xylol) von ca. 1000 mPa.s (DIN 53019, 23°C) erreicht ist. Nach Abkühlen auf 110°C wird 0,03 %, bezogen auf 100 % Feststoff, Toluhydrochinon (Stabilisator) zugegeben.

**Tabelle 1**

| Komponente A) | A1 | A2 | A3 | A4 | A5 | A6 |
|---|---|---|---|---|---|---|
| | | | | | | |

| Ausgangsmaterialien (Gew.-%) | | | | | | |
|---|---|---|---|---|---|---|
| Phthalsäureanhydrid | 26,3 | 26,2 | 26,3 | 28,6 | 40,4 | 41,5 |
| Benzoesäure | 12,2 | 12,1 | 12,2 | 20,1 | | 13,0 |
| Sojaölfettsäure | 46,5 | | | 35,0 | 32,6 | 15,6 |
| Sonnenblumenölfettsäure | | 46,7 | | | | |
| Erdnußölfettsäure | | | 46,5 | | | |
| Pentaerythrit | 23,0 | 22,9 | 23,0 | 25,0 | | |
| Trimethylolpropan | | | | | 34,0 | 36,8 |

| Kenndaten | | | | | | |
|---|---|---|---|---|---|---|
| Säurezahl (mg KOH/g Substanz) | 4 | 6 | 4 | 14 | 11 | 16 |
| Viskosität 60 %ig in Xylol | 1050 | 980 | 1010 | 990 | 1300 | 1125 |
| (mPa.s/23°C/DIN 53019) | | | | | | |

### II. Herstellung und Verwendung der erfindungsgemäßen Beschichtungsmittel

Jeweils 40 Gewichtsteile der Komponenten A1 bis A5 werden mit 60 Gewichtsteilen Dipropylenglykoldiacrylat und 5 Gewichtsteilen 1-Phenyl-2-hydroxy-2-methylpropan-1-on (Fotoinitiator) gemischt.

Nach Auftragen von Lackfilmen auf
a) farbig bedruckten Karton (30 µm Auftragsstärke)
b) Teakholzfumier (60 µm Auftragsstärke)
c) Metallblech (Bonder WH 60 OC / 40 µm Auftragsstärke)
werden diese unter einem Hanoviastrahler (80 W/cm, 10 cm Abstand) durchbewegt.

Die Lacke auf den Substraten a) und b) werden mit 5 m/Min. Bandgeschwindigkeit, die Lacke auf dem Substrat c) mit 1 m/Min. Bandgeschwindigkeit zu lösemittel- und kratzfesten Überzüge ausgehärtet, die eine ausgezeichnete Haftung zum jeweiligen Untergrund besitzen.

Lösemittelfest bedeutet in diesem Fall, daß der Lackfilm nach mindestens 20 Doppelhüben mit einem in Butylacetat getränkten Tuch, unter 1 kg Belastung, noch einwandfrei aussieht.

Die Kratzfestigkeit wird mit dem Fingernagel geprüft.

Zur Beurteilung der Haftung der Beschichtung wird eine Gitterschnittprüfung durch Einritzen eines Rasters von 6 x 6 Linien mit einem Abstand von jeweils 1 mm in die Beschichtung mit anschließendem Aufdrücken sowie schnellem Abziehen eines Klebebandes durchgeführt.

### III. Vergleichsbeispiel

40 Gewichtsteile der Komponente A6, die eine nicht erfindungsgemäße Menge an Fettsäure enthält, wird mit 60 Gewichtsteilen Dipropylenglykoldiacrylat und 5 Gewichtsteilen 1-Phenyl-2-hydroxy-2-methylpropan-1-on (Fotoinitiator) gemischt.

Nach Auftragen von Lackfilmen auf
a) farbig bedruckten Karton (30 µm Auftragsstärke)
b) Teakholzfurnier (60 µm Auftragsstärke)
c) Metallblech (Bonder WH 60 OC / 40 µm Auftragsstärke)
werden diese unter einem Hanoviastrahler (80 W/cm, 10 cm Abstand) durchbewegt.

Die Lacke auf den Substraten a) und b) werden mit 5 m/Min. Bandgeschwindigkeit, der Lack auf dem Substrat c) mit 1 m/Min. Bandgeschwindigkeit zu Überzügen ausgehärtet, deren Lösemittel- und Kratzfestigkeiten wesentlich schlechter sind als bei den erfindungsgemäßen Beispielen. Die Überzüge besitzen keine Haftung auf den genannten Untergründen.

## Patentansprüche

1. Durch Strahlen härtbare Lackkomposition aus
I) 0 bis 95 Gew.-Teilen mindestens eines strahlenhärtbaren Bindemittels mit Maleinat und/oder Fumarat und/oder Acryloylgruppen.
II) 5 bis 100 Gew.-Teilen eines Gemischs aus
A) 20 bis 80 Gew.-Teilen mindestens eines Fettsäure-modifizierten Polyesterharzes
B) 20 bis 80 Gew.-Teilen (Meth)Acryloylgruppen enthaltender Verbindungen einer Viskosität bei 23°C von 10 bis 1.000 mPa.s und des Molekulargewichtsbereichs Mₙ 170 bis 1.000,
wobei die Summe der Gewichtsteile I) und II) sowie A) und B) jeweils 100 beträgt, sowie gegebenenfalls
III) aus der Technologie der Polyesterharze bekannten weiteren Hilfs- und Zusatzstoffen,
dadurch gekennzeichnet, daß die Komponente A) mindestens 20 Gew.-% einer Fettsäure des Molekulargewichtsbereichs Mₙ 112 bis 400 enthält.

2. Verwendung von durch Strahlen härtbaren Kompositionen nach Anspruch 1 zur Herstellung von Überzügen.

3. Lack enthaltend Kompositionen nach Anspruch 1.
